# EUROPEAN PATENT SPECIFICATION

(11) **EP 2 340 565 B1**
(45) Date of publication and mention of the grant of the patent: **17.02.2016**
(21) Application number: 09753325.1
(22) Date of filing: 25.05.2009
(51) Int. Cl.: H01L 31/04, H01L 31/052, H01G 9/20, H01L 51/44

(54) **OPTICAL ENHANCEMENT FOR SOLAR DEVICES**
OPTISCHE VERSTÄRKUNG FÜR SOLARELEMENTE
AMÉLIORATION OPTIQUE POUR DISPOSITIFS SOLAIRES

(30) Priority: 25.05.2008 AU 2008902566
(43) Date of publication of application: 06.07.2011
(73) Proprietor: 3GSolar Photovoltaics Ltd., 97774 Jerusalem (IL)
(72) Inventor: SKRYABIN, Igor, Lvovich, Yarralumla, ACT 2600 (AU); BREEN, Barry, Givat Zeev 90917 (IL); YAKUPOV, Ilya, Rehovot 76229 (IL); GOLDSTEIN, Jonathan, Jerusalem 95470 (IL)
(74) Representative: Messulam, Alec Moses
(86) International application number: PCT/AU2009/000649
(87) International publication number: WO 2009/143561

(56) References cited:
- EP-A1- 1 463 073
- EP-A1- 1 724 621
- EP-A2- 0 559 141
- WO-A1-2008/012079
- WO-A1-2008/024206
- WO-A2-03/107078
- US-A- 5 656 098
- US-A1- 2005 000 792
- US-A1- 2005 166 958
- US-A1- 2005 166 959
- US-A1- 2006 048 812
- US-A1- 2006 102 226
- US-A1- 2006 219 289
- US-A1- 2007 079 870

## Description

### TECHNICAL FIELD

This invention relates to devices for conversion of solar energy into other forms of energy, including photovoltaic devices such as Dye Solar Cells and polymer solar cells; devices for photo-electrochemical splitting of water; and for solar purification of water.

### BACKGROUND OF THE INVENTION

Solar devices are employed for conversion of light energy into other forms of energy, such as an electrical output or chemical energy, either stored within the devices or released from the devices in form of hydrogen. In some solar devices chemical energy is utilised in chemical reactions occurring within solar devices, leading to purification of water.

The solar devices are commonly separated from the environment by a substrate, through which light enters the devices. Light enters the substrate though its outer face and exits the substrate through an inner face, on which solar device layers are formed. Where electrical connections are required, the inner face of the substrate is coated by an optically transparent conductor such as, for example, indium tin oxide.

In some cases the nano-particulate layer is formed directly on an inner face of the substrate; in other cases - the nano-particulate layer and the substrate are separated by an electrolyte. In most cases the inner face of the substrate is coated by a transparent electronic conductor.

In Dye Solar Cell photovoltaic devices the device layers include a photosensitised layer of nano-particulate wide-bang-gap semiconductor, usually comprising titanium dioxide. Nano-particulate material of this layer is immersed into a redox electrolyte, electrically connecting the photosensitised layer to a counter electrode of a Dye Solar Cell device.

In a polymeric photovoltaic device the device layers include a polymeric material formed on a transparent conductor of the inner face of the substrate.

In water splitting and water purification solar devices the device layers include a nano- particulate layer (typically comprising metal oxide) adjacent to the inner face of the substrate. As in DSC devices, solar energy is absorbed in the nano-particulate layer immersed in a liquid.

Common feature of these devices is that the refractive index of the substrate is very close to that of device layers. Refraction of light occurs on the outer face of the substrate.

Poor absorption of light in the device layers is one of the major causes of inadequate efficiency of solar devices. Also, UV part of solar radiation causes degradation in Dye Solar Cell and polymeric photovoltaic devices.

### PRIOR ART

EP 0 559 141 discloses a photovoltaic device having a semiconductor layer; electrodes; and a surface protection layer adjacent to the light incident side, wherein granules of a material different from those of the surface protection layer are disposed in the surface protection layer.

EP 1463 073 discloses a porous film for use in an electronic device, uses of such a porous film, a method of producing a porous film and a porous film produced by said method, whereby the porous film has a gradient of light scattering strength.

WO2008/012079 discloses an organic solar cell comprising at least one light-permeable, particularly transparent, organic functional layer which increases the efficiency of the solar cell and is provided with light-scattering and/or luminescent particles, and/or at least one light-permeable, particularly transparent, organic or inorganic functional layer that increases the efficiency of the solar cell, has a refractive index lying between the refractive index of air and the refractive index of a light-permeable electrode layer of the solar cell, and/or is fitted with at least one first relief structure reducing reflection.

US2006/102226 discloses a method for producing the photoelectrode of a solar cell in which a layer of a nanocrystalline semiconductor material is applied on a substrate and then sintered at a sintering temperature. In the method, elongated particles which burn out at the sintering temperature and leave elongated cavities in the layer are introduced into the layer. The invention also relates to a solar cell having a photoelectrode which has such type cavities. The method permits producing photoelectrodes for dye solar cells which allow sufficient diffusion of the electrolyte into the photoelectrode and thus a sufficiently great photocurrent even in the case of high viscous electrolytes.

### OBJECTIVE OF THE INVENTION

It is an object of the present invention to overcome or ameliorate at least one disadvantage of the prior art, or to provide a useful alternative.

### SUMMARY OF THE INVENTION

The invention provides a solar device comprising a transparent polymeric substrate having an outer face, through which light enters the substrate and an inner face through which light exits the substrate and enters device layers where light energy is absorbed and converted into other forms of energy, wherein the substrate comprises a light deflection means such that in use the light deflection means deflects at least a portion of exiting light towards a plane defined by the inner face of the substrate; wherein
light energy is converted into electricity and the device layers comprise a photosensitised wide-band-gap semiconductor formed on a transparent conductor attached to the substrate; the semiconductor including a nano-particulate semiconductor,
the light deflection means comprise light scattering centres embedded in the polymeric substrate; and
the light scattering centres are cavities.

In some embodiments, the semiconductor is titanium dioxide.

### BRIEF DESCRIPTION OF DRAWINGS

Having broadly portrayed the nature of the present invention, embodiments thereof will now be described by way of example and illustration only. In the following description, reference will be made to the accompanying drawings in which:
Figure 1 is a cross-sectional representation of a solar device,
Figure 2 is a cross-sectional representation of a solar device,
Figure 3 is a cross-sectional representation of a solar device, and
Figure 4 is a cross-sectional representation of a solar device.

### DETAILED DESCRIPTION OF DRAWINGS

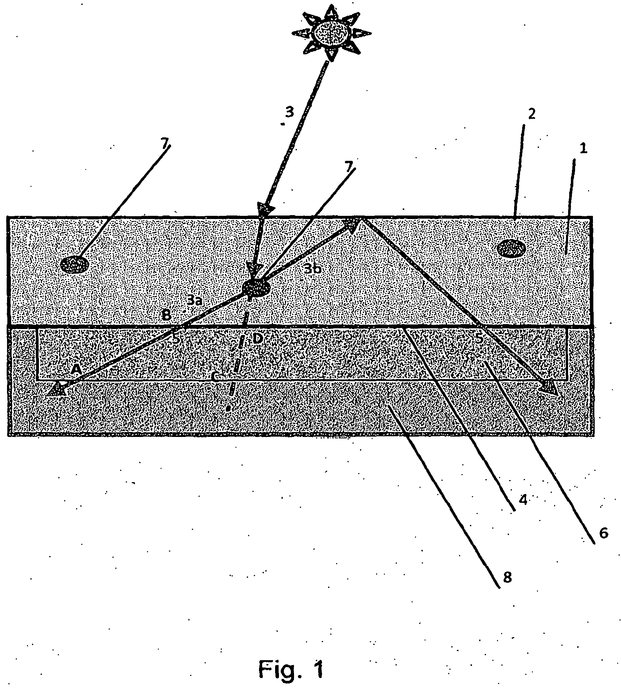

With reference to Figure 1, a solar device, not forming part of the invention, comprises a glass or polymeric substrate 1, having an outer face 2 through which light rays 3 enter the substrate and an inner face 4 through which light rays 5 exit the substrate. A dye-sensitised nano-particulate layer 6 of titanium dioxide is formed on the inner face of the substrate and immersed into an electrolyte 8. Light deflecting centres 7 are embedded into the substrate 1.

An incident light 3, refracted on the interface between the outer face of the substrate and atmosphere, 'hits' the deflection centre 7 (e.g. fluorescent dye). The deflection centre deflects light in various directions, including rays 3a and 3b. Since the inner face of the substrate interfaces with an electrolyte, having practically the same refractive index as the substrate, there is no noticeable refraction on this interface. Therefore, light ray 3a exits the substrate being deflected towards a plane defined by its inner face 4. Also shown is ray 3b that exits the substrate after the reflection on the substrate outer face.

It can be seen that the light-path in the dye sensitised nano-particulate layer is longer for the deflected ray (AB) than for that of the original non-deflected ray (CD).

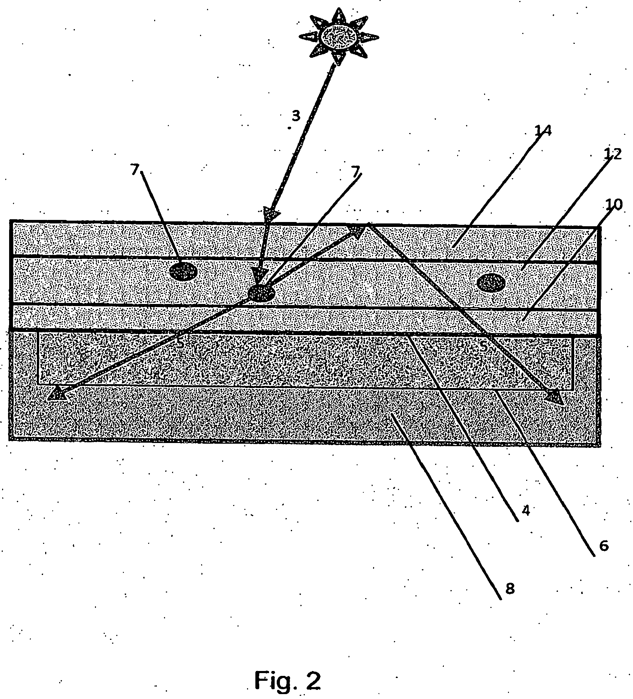

With reference to Fig. 2, a substrate, not forming part of the invention, comprises a first and a second substrate layers. The first substrate layer 10 is adjacent to the device layers and the second substrate layer 14 interfaces with the environment. Each of the first and the second substrate layers is optically transparent. The first and the second substrate layers are joined by a transparent glue 12 such as silicone, PVA, polyurethane or any other suitable material. The device layers comprise a dye sensitized wide-band-gap semiconductor 6 adjacent to the inner face 4 of the first substrate layer 10 and an electrolyte 8. A light deflection means 7, such as particles of zirconium dioxide is embedded into the transparent glue 12.

An incident solar radiation 3 refracted on the interface between air and the second device layer 14 is deflected by the deflection means 7 causing an increased optical path of deflected rays 5.

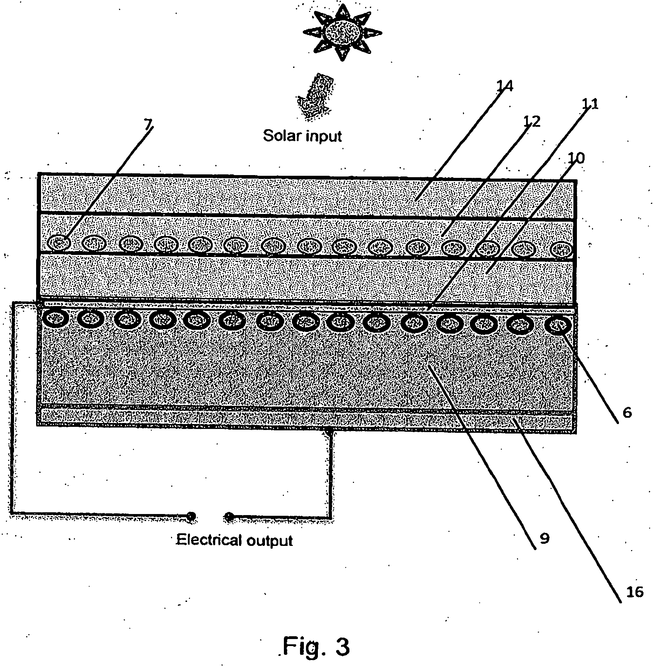

With reference to Fig. 3 a solar photovoltaic device, not forming part of the invention, includes a substrate comprising a glass pane 10 and a polymeric sheet 14 joined by a transparent glue 12. The glass pane 10 is a commercially available glass, one face of which is coated with a transparent conductor 11. A layer of nano-particulate titanium dioxide 6 is formed on the transparent conductor layer 11 of the glass pane 10. Also, another layer of nano- particulate titanium dioxide 7 is formed on the other face of the glass pane 10. Both layers can be formed by using any suitable technology, including screen-printing and spraying.

A layer of titanium dioxide 6 is photosensitised by a light absorbing dye and immersed into an electrolyte 9, electrically connecting the photosensitised layer with a catalytic counter electrode 16. An electrical output of the device is formed between the transparent conductor 11 and the counter electrode 16.

Nano-particulate layer 7 serves both as a light deflection means and a UV absorber, thus increasing both efficiency and longevity of the solar device.

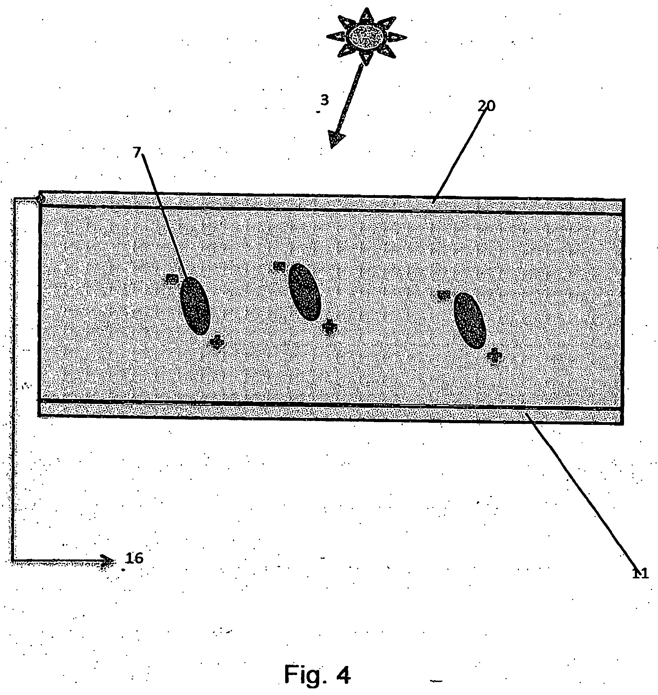

With reference to Fig. 4, a light scattering means 7, not forming part of the invention, are dipoles, orientation of which can be controlled by an external electrical field applied between a transparent conductor 11 formed on the inner face of substrate and another transparent conductor 20 formed on the outer face of the substrate. Electrical potential of the transparent conductor 11 is the same as that of a layer of dye sensitised nano-particulate semiconductor (not shown) formed on the transparent conductor 11. Electrical potential of the transparent conductor 20 is controlled to ensure optimum scattering when an angle of incidence of light changes.

## Claims

1. A solar device comprising a transparent polymeric substrate (1) having an outer face (2), through which light enters the substrate and an inner face (4) through which light exits the substrate and enters device layers where light energy is absorbed and converted into other forms of energy, wherein the substrate comprises a light deflection means (7) such that in use the light deflection means deflects at least a portion of exiting light towards a plane defined by the inner face (4) of the substrate; wherein
light energy is converted into electricity and the device layers comprise a photosensitised wide-band-gap semiconductor (6) formed on a transparent conductor attached to the substrate; the semiconductor including a nano-particulate semiconductor,
the light deflection means (7) comprises light scattering centres embedded in the polymeric substrate (1); and
the light scattering centres are cavities.

2. A solar device as claimed in claim 1, wherein the semiconductor is titanium dioxide.

## Patentansprüche

1. Solargerät, umfassend ein transparentes Polymersubstrat (1) mit einer Außenfläche (2), durch die Licht in das Substrat eintritt, und einer Innenfläche (4), durch die Licht aus dem Substrat austritt und in Geräteebenen eintritt, wo Lichtenergie absorbiert und in andere Formen von Energie umgewandelt wird, wobei das Substrat ein Lichtablenkungsmittel (7) umfasst, sodass das Lichtablenkungsmittel bei Verwendung zumindest einen Teil austretenden Lichts in Richtung einer Plane, die durch die Innenfläche (4) des Substrats definiert ist, ablenkt; wobei
Lichtenergie in Elektrizität umgewandelt wird und die Geräteebenen einen photosensibilisierten Halbleiter mit großer Bandlücke (6) umfassen, der auf einem transparenten Leiter gebildet ist, der am Substrat angebracht ist; wobei der Halbleiter einen nanopartikulären Halbleiter beinhaltet,
das Lichtablenkungsmittel (7) Lichtstreuungszentren umfasst, die in das Polymersubstrat (1) eingebettet sind; und
die Lichtstreuungszentren Hohlräume sind.

2. Solargerät nach Anspruch 1, wobei der Halbleiter Titandioxid ist.

## Revendications

1. Un dispositif solaire, comprenant un substrat polymérique transparent (1), possédant une face externe (2) par laquelle la lumière pénètre dans le substrat, et une face interne (4) par laquelle la lumière sort du substrat et pénètre dans des couches du dispositif où l'énergie lumineuse est absorbée et convertie sous d'autres formes d'énergie, le substrat comprenant un appareil de déviation de la lumière (7) tel qu'en cours d'usage l'appareil de déviation de la lumière dévie au moins une partie de la lumière sortant en direction d'un plan défini par la face interne (4) du substrat ;
l'énergie lumineuse étant convertie en électricité, et les couches du dispositif comprenant un semi-conducteur à large écart énergétique photosensibilisé (6), formé sur un conducteur transparent fixé au substrat, le semi-conducteur comprenant un semi-conducteur à nanoparticules,
l'appareil de déviation de la lumière (7) comprenant des centres de diffusion de la lumière incorporés dans le substrat polymérique (1) ; et
les centres de diffusion de la lumière étant des cavités.

2. Un dispositif solaire selon la revendication 1, dans lequel le semi-conducteur est du dioxyde de titane.
